# EUROPEAN PATENT SPECIFICATION

(11) **EP 2 009 715 B1**
(45) Date of publication and mention of the grant of the patent: **24.07.2019**
(21) Application number: 08252229.3
(22) Date of filing: 27.06.2008
(51) Int. Cl.: H01L 51/52, H01L 51/56

(54) **Light emitting display and method of manufacturing the same**
Lichtemittierende Anzeige und Herstellungsverfahren dafür
Affichage électroluminescent et son procédé de fabrication

(30) Priority: 28.06.2007 KR 20070064293
(43) Date of publication of application: 31.12.2008
(73) Proprietor: Samsung Display Co., Ltd., Gyeonggi-do (KR)
(72) Inventor: Oh, Min-Ho, Suwon-si Gyeonggi-do (KR); Cho, Yoon-Hyeung, Suwon-si Gyeonggi-do (KR); Lee, Byoung-Duk, Suwon-si Gyeonggi-do (KR); Lee, So-Young, Suwon-si Gyeonggi-do (KR); Lee, Sun-Young, Suwon-si Gyeonggi-do (KR); Kim, Won-Jong, Suwon-si Gyeonggi-do (KR); Choi, Jin-Baek, Suwon-si Gyeonggi-do (KR); Lee, Jong-Hyuk, Suwon-si Gyeonggi-do (KR); Lee, Seung-Han, Suwon-si Gyeonggi-do (KR); Kim, Yong-Tak, Suwon-si, Gyeonggi-do (KR)
(74) Representative: Mounteney, Simon James

(56) References cited:
- EP-A2- 1 253 643
- DE-A1-102005 044 523
- GB-A- 2 383 683
- JP-A- 2000 068 050
- JP-A- 2002 280 169
- KR-B1- 100 671 647
- US-A- 4 446 399
- US-A1- 2003 042 852
- US-A1- 2004 095 060
- US-A1- 2005 269 940

## Description

### BACKGROUND

### Technical Field

This disclosure relates to a light emitting display and a method of manufacturing the same, and more particularly to, a light emitting display seal comprising an inorganic sealing material and a method of manufacturing the same.

### Discussion of Related Art

Since a light emitting device such as an organic light emitting diode (OLED) includes organic materials vulnerable to moisture and/or oxygen, it is desirable to protect the OLED against moisture and/or oxygen.

Since a light emitting display using an OLED typically has a wide viewing angle, high contrast and response speed, and low power consumption, in spite of its vulnerability to moisture and/or oxygen, light emitting displays are widely used in personal portable apparatus, such as MP3 players, mobile telephones, and televisions (TV). The thicknesses of light emitting displays have been gradually reduced in accordance with the requests of users.

However, when the thickness of a substrate of a light emitting display is reduced to no more than about 0.3 mm in order to reduce the thickness thereof, it is difficult to maintain the mechanical integrity of the device under stresses such as falling and twisting. Loss of mechanical integrity can compromise the sealed state of the device, thereby reducing the life of the organic light emitting display.

GB2383683 discloses housing structure for a display device, such as an OLED, LCD or other luminescent display, comprising a sealing structure comprised of a first sealing layer and a second sealing layer which seals the transparent substrate to the bonding rim of sealing cap. JP2002-280169 disclosed an organic EL device with a first substrate and a second substrate. Barrier ribs are provided between the first and second substrates so as to surround an organic EL element. A water catching part is formed on an inner surface of the second substrate between the barrier ribs. An outer barrier rib is provided around an outer diameter of the barrier ribs.

US2003/042852 discloses a light emitting display that has a dam member and an inorganic sealing material.

JP2000-068050 discloses a UV adhesive that is injected into a gap between a first substrate and a second substrate, so as to fill the space between the substrate.

US2004/095060 discloses that an ultraviolet-ray shield resin film is provided for shielding ultraviolet rays provided from a sealing area between a first substrate and a sealant.

### SUMMARY OF THE INVENTION

Accordingly, it is an object to provide a light emitting display capable of securing mechanical reliability and of increasing a life and a method of manufacturing the same.

It is another object to provide a light emitting display capable of securing mechanical reliability while using an inorganic sealing material that effectively prevents moisture or oxygen from penetrating and a method of manufacturing the same.

The present invention provides a light emitting display according to claim 1. Embodiments of the display exhibit one or more of improved resistance to moisture and/or oxygen infiltration, and improved mechanical reliability of the seal. Some embodiments also exhibit reduced Newton's ring.

The present invention also provides a method of manufacturing a light emitting display according to claim 11.

In some embodiments, the reflecting layer comprises at least one of Au, Ag, Pt, and Al. In some embodiments, at least a portion of the dam member contacts the inorganic sealing material.

In some embodiments, the frit comprises a transition metal compound.

In some embodiments, at least a portion of the filling material contacts the second substrate. In some embodiments, the filling material comprises a solid material. In some embodiments, the filling material comprises a heat, electron beam, and/or UV radiation hardening material. In some embodiments, the filling material comprises at least one of epoxy, epoxy acrylate, urethane, urethane acrylate, urethane acrylic, allyl resin, silicone, bisphenol A type epoxy silicone, cycloaliphatic epoxy silicone resin, acrylic epoxy silicone resin, allyl ether silicone, allyl methacrylate silicone, phenyl silicone resin, aliphatic urethane acrylate, and rubber.

In some embodiments, the filling material comprises a liquid material. In some embodiments, the filling material comprises silicone and/or silicone oil. In some embodiments, the filling material comprises at least one of hexamethyldisiloxane, octamethyltrisiloxane, decamethyltetrasioxane, dodecamethylpentasiloxane, and polydimethylsiloxanes.

In some embodiments, disposing the inorganic sealing material comprises: applying frit paste; and drying and/or annealing the frit paste.

In some embodiments, disposing the dam member comprises: applying frit paste; and drying and/or annealing the frit paste, thereby hardening the frit paste. In some embodiments, at least a portion of the dam member contacts the inorganic sealing material.

In some embodiments, securing the inorganic sealing material to the first substrate and the second substrate to face each other is performed at a pressure lower than atmospheric pressure. In some embodiments, the pressure is from about 1 Pa to about 10,000 Pa.

Some embodiments further comprise compressing the first substrate and the second substrate, thereby filling with the liquid filling material spaces between the light emitting devices and the second substrate within the dam member. Some embodiments further comprise hardening the liquid filling material.

In the present invention securing the inorganic sealing material to the first substrate and the second substrate comprises melting the inorganic sealing material, wherein the inorganic sealing material is melted by laser and/or IR radiation.

### BRIEF DESCRIPTION OF THE DRAWINGS

These and/or other embodiments and features will become apparent and more readily appreciated from the following description of certain embodiments, taken in conjunction with the accompanying drawings of which:
FIG. 1 is a perspective view illustrating an embodiment of a light emitting display;
FIG. 2 is a cross-sectional view taken along section line 11-12 of FIG. 1;
FIGs. 3A and 3B are plan views illustrating an embodiments of a method of manufacturing the light emitting display; and
FIGs. 4A to 4F are cross-sectional views illustrating the embodiment of the method of manufacturing the light emitting display.

### DETAILED DESCRIPTION OF EMBODIMENTS

Hereinafter, certain embodiments will be described with reference to the accompanying drawings. Here, when a first element is described as being coupled to a second element, the first element may be not only directly coupled to the second element but may also be indirectly coupled to the second element via one or more third elements. Further, elements that are not essential to a complete understanding are omitted for clarity. Also, like reference numerals refer to like elements throughout.

In order to increase the life of an organic light emitting display, the invention uses an inorganic sealing material comprising frit that effectively prevents moisture and/or oxygen from penetrating. However, when frit is used, mechanical reliability deteriorates in some embodiments.

Therefore, some embodiments provide a light emitting display capable of increasing a life and of improving mechanical reliability using an inorganic sealing material comprising frit that effectively prevents moisture and/or oxygen from penetrating and a method of manufacturing the same.

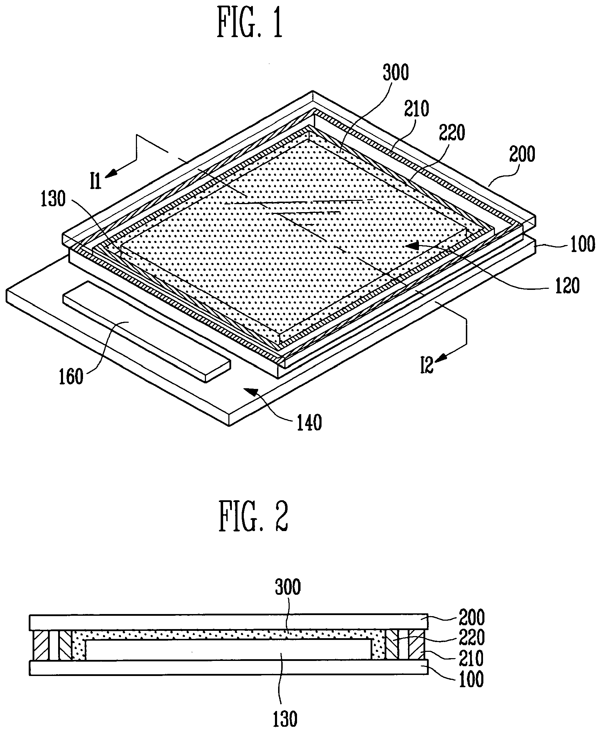

FIG. 1 is a perspective view illustrating an embodiment of a light emitting display. FIG. 2 is a cross-sectional view taken along section line 11-12 of FIG. 1.

Referring to FIGS. 1 and 2, the light emitting display includes a substrate 100 on which a plurality of light emitting devices 130 is formed, a sealing substrate 200 facing the substrate 100, a dam member 220 provided between the substrate and the sealing substrate 200, which surrounds the plurality of light emitting devices 130, an inorganic sealing material 210 provided between the substrate 100 and the sealing substrate 200 outside the dam member 220, which couples the substrate 100 with the sealing substrate 200, an a filling material 300 provided inside the dam member 220 to cover the plurality of light emitting devices 130.

The substrate 100 is divided into a pixel region 120 and a non-pixel region 140 around the pixel region 120. The plurality of light emitting devices 130 is formed in the pixel region 120 and a driving circuit 160 for driving the plurality of light emitting devices 130 is formed in the non-pixel region 140. The light emitting devices 130 can be formed of organic light emitting diodes (OLED) that include anode electrodes, organic thin layers, and cathode electrodes.

The sealing substrate 200 is provided to overlap the pixel region 120 and a part of the non-pixel region 140. In the case of a front emission type of display, the sealing substrate 200 can be formed of a transparent material such as glass. In the case of a rear emission type, the sealing substrate can be formed of an opaque material.

The inorganic sealing material 210 comprises a frit, which is melted by laser or infrared red (IR) rays to the substrate 100 and the sealing substrate 200. The inorganic sealing material 210 is provided between the substrate 100 and the sealing substrate 200 surrounding the light emitting devices 130 so that moisture and/or oxygen penetration from the outside is prevented and/or reduced.

The dam member 220 prevents the flow of the filling material 300 so that the shape of the filling material 300 is maintained. The dam member 220 comprises a frit and reduces or prevents heat from being transmitted to the light emitting devices 130 when the inorganic sealing material 210 is attached to the substrate 100 and the sealing substrate 200.

The dam member 200 comprises, frit, A reflecting layer is formed on the surface of the dam member 220 using metal having a high reflectance in an IR region such as Au, Ag, Pt, and/or Al so that laser or IR radiation is reflected.

The dam member 220 may contact the inorganic sealing material 210 or may be separated from the inorganic sealing material 210 by a predetermined distance.

The filling material 300 is provided on the internal side of the region defined by the dam member 220 to cover the light emitting devices 130. In the illustrated embodiment, the filling material 300 is provided between the light emitting devices 130 and the sealing substrate 200 to contact the dam member 220 and the sealing substrate 200. The filling material 300 can comprise a colorless solid or liquid material having a transmittance of no less than about 95% within a thickness of about 30 µm.

For example, the solid material can comprise at least one of epoxy, epoxy acrylate, urethane, urethane acrylate, urethane acrylic, allyl resin, silicone (such as bisphenol A type epoxy, cycloaliphatic epoxy resin, acrylic epoxy resin, allyl ether, allyl methacrylate, and phenyl silicone resin), aliphatic urethane acrylate, and rubber. After a liquid material is filled therein, it may be hardened by heat, electron beam, or UV radiation. In some embodiments, the liquid material is molded into a film which is attached to the solid material.

In addition, a liquid material can be silicone or silicone oil that exhibits no change in phase and a volume change ratio within 5% at temperatures ranging from about -40 °C to about 100 °C, for example, comprising at least one material selected from the group consisting of hexamethyldisiloxane, octamethyltrisiloxane, decamethyltetrasioxane, dodecamethylpentasiloxane, polydimethylsiloxane, etc.

A method of manufacturing a light emitting display will now be described in detail.

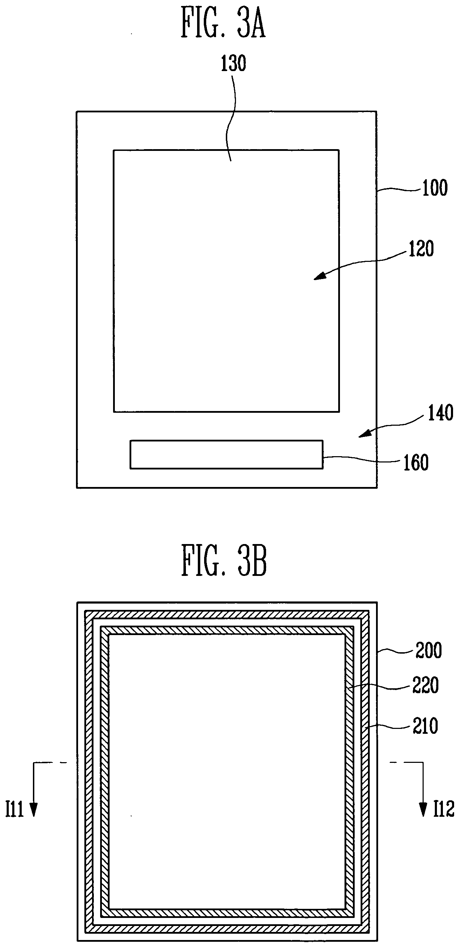

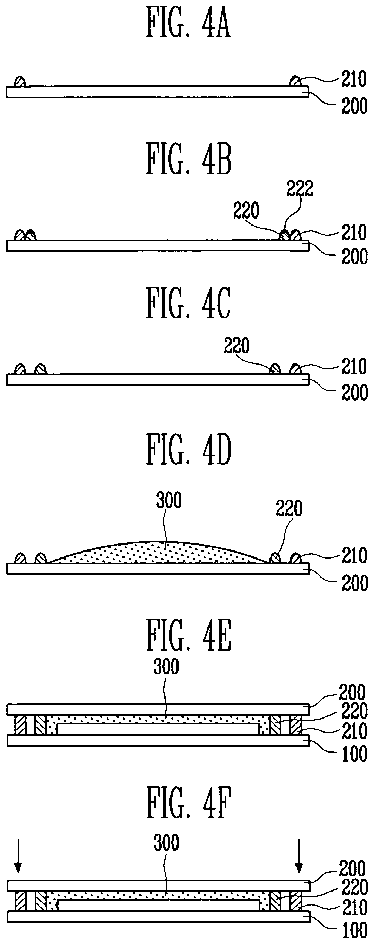

FIGS. 3A and 3B are plan views illustrating an embodiment of a method of manufacturing the light emitting display. FIGS. 4A to 4F are cross-sectional views illustrating the embodiment of the method of manufacturing the light emitting display. FIGS. 4A to 4D are cross-sectional views taken along section line I11-I12 of FIG. 3B.

Referring to FIG. 3A, first, the substrate 100 on which the plurality of light emitting devices 130 is formed is provided. The substrate is divided into the pixel region 120 and the non-pixel region 140 around the pixel region 120. The plurality of light emitting devices 130 can be formed in the pixel region 120 of the substrate and the driving circuit 160 for driving the light emitting devices 130 can be formed in the non-pixel region 140.

The light emitting devices 130 comprise the OLED including the anode electrodes, the organic thin layers, and the cathode electrodes. The light emitting devices 130 can further include thin film transistors (TFT) for controlling the operation of the OLEDs and capacitors for maintaining signals. Processes of manufacturing the OLED are illustrated in the Korean Patent Publication Nos. 2002-0047889 (published on June 22, 2002) and 2003-0092873 (published December 6, 2003).

Referring to FIGS. 3B and 4A, the sealing substrate 200 for sealing the light emitting devices 130 of the pixel region 120 is provided. The sealing substrate 200 can overlap the pixel region 120 and a part of the non-pixel region 140. A transparent substrate such as glass having the front emission structure or an opaque substrate having the rear emission type can be used as the sealing substrate 200.

An inorganic sealing material 210 is disposed on the outer circumference of the sealing substrate 200. The inorganic sealing material 210 comprises a frit using dispensers and/or using a screen printing method.

After the inorganic sealing material 210 is disposed on the internal side of the sealing substrate 200, a washing process can be performed.

Referring to FIGS. 3B, 4B, and 4C, the dam member 220 is disposed on the sealing substrate 200 on the inward or internal side of the inorganic sealing material 210, thereby surrounding the pixel region 120. The dam member 220
is applied by any suitable method, for example using dispensers or by screen printing. At this time, the amount of the inorganic material is determined in consideration of the distance from the light emitting devices 130 on the outermost circumference of the pixel region to the inorganic sealing material 210 and the height of the dam member 220. The height of the dam member 220 can be determined by the height of the inorganic sealing material 210 so that the height of the inorganic sealing material 210 is about equal to or less than the height of the dam member 220.

Frit is used as the inorganic material. In this case, the dam member 220 can be formed in a process of forming the inorganic sealing material 210. A metal reflecting layer 222 is disposed on the surface of the dam member 220 in order to reflect laser or IR rays as illustrated in FIG. 4B. For example, after applying the paste frit, the paste frit is dried or annealed, and hardened to form the dam member 220. Then, the metal such as Au, Ag, Pt, and/or Al having a high reflectance in the IR ray region is applied onto the surface of the dam member 220 to form the reflecting layer 222.

The dam member 220 can contact the inorganic sealing material 210 as illustrated in FIG. 4B or can be separated from the inorganic sealing material 210 by a predetermined distance as illustrated in FIG. 4C.

In another embodiment, in a process of forming the inorganic sealing material 210 or the dam member 220, a dummy sealing material (not shown) can be formed of epoxy and frit on the outermost circumference of the sealing substrate 200. The dummy sealing material is formed on the outside of the sealing material 210 to collectively seal up the space between the substrate 100 and the sealing substrate 200. In the case of a mother substrate on which a plurality of light emitting displays is simultaneously manufactured, the dummy sealing material is disposed on the outermost circumference thereof.

Referring to FIG. 4D, the filling material 300 is disposed on the sealing substrate 200 on the inward or internal side of the region defined by the dam member 220. The filling material 300 can comprise a colorless solid or liquid material having a thickness of less than about 30 µm and a transmittance of not less than about 95%. For example, the solid material can be selected from epoxy, epoxy acrylate, urethane, urethane acrylate, urethane acrylic, allyl resin, silicone (such as bisphenol A type epoxy, cycloaliphatic epoxy resin, acrylic epoxy resin, allyl ether, allyl methacrylate, and phenyl silicone resin), aliphatic urethane acrylate, rubber, and combinations thereof. The liquid material can be a silicone or silicone oil that exhibits no change in phase and a volume change ratio within about 5% in the temperature range of from about -40 °C to about 100 °C such as hexamethyldisiloxane, octamethyltrisiloxane, decamethyltetrasioxane, dodecamethylpentasiloxane, polydimethylsiloxane, or etc. After the sealing substrate 200 is filled with the filling material 300, the filling material 300 is cured and hardened by heat, electron beam, and/or UV radiation.

For example, the proper amount of liquid filling material 300 can applied to the sealing substrate 200 on the internal side of the dam member 220 using a one drop filling (ODF) device. In this case, the proper amount of filling material 300 in proportion to the volume of the internal space can be easily controlled.

Referring to FIG. 4E, the substrate 100 is disposed facing the sealing substrate 200. For example, after the substrate 100 is mounted on an upper chuck of an attaching device and the sealing substrate 200 is mounted on a lower chuck of the attaching device, the substrate 100 and the sealing substrate 200 are attached to each other. As the substrate 100 and the sealing substrate 200 are attached to each other, the light emitting devices 130 are covered with the filling material 300 and the flow of the filling material 300 is prevented by the dam member 220 so that the shape is maintained. At this time, the substrate 100 and the sealing substrate 200 are attached to each other under a pressure lower than atmospheric pressure, for example, from about 1 Pa to about 100,000 Pa so that bubbles and/or voids are not formed between the substrate 100 and the sealing substrate 200. In addition, the substrate 100 and the sealing substrate 200 are pressed together so that the space between the light emitting devices 130 and the sealing substrate 200 is completely filled with the filling material 300. The filling material 300 can be hardened by heat, electron beam, or UV radiation after the substrate 100 and the sealing substrate 200 are attached to each other.

Referring to FIG. 4F, laser and/or IR radiation are projected onto the inorganic sealing material 210 after the substrate 100 and the sealing substrate 200 are attached to each other. As the laser or IR rays are absorbed to generate heat, the inorganic sealing material 210 is attached to the substrate 100 and the sealing substrate 200 by melting, so that the light emitting devices 130 are sealed. Such a sealing process is performed after the dummy sealing material is hardened so that the space between the substrate 100 and the sealing substrate 200 is maintained.

When laser or IR radiation are projected onto the inorganic sealing material 210, a mask or a protecting film (not shown) is used so that laser or IR radiation are projected onto only a desired region. A reflecting layer 222 is disposed on the surface of the dam member 220, the mask or the protecting film is disposed only in the pixel region 120 so that laser or IR radiation are not projected thereon.

According to the above embodiment, the inorganic sealing material 210 seals only the pixel region 120. In other embodiments, the inorganic sealing material 210 can also seal the driving circuit 160. In addition, according to the above embodiment, the inorganic sealing material 210 and the dam member 220 are integrated with each other on the sealing substrate 200. In other embodiments, the inorganic sealing material and the dam member can be integrated with each other on the substrate 100 to have a double or multiple structure. For example, in order to improve sealing effect, the inorganic sealing material 210 can comprise a double or multiple structure, and/or the dam member 220 comprise a double or multiple structure in order to improve heat shielding effect.

In addition, according to the above embodiment, the filling material 300 is filled before attaching the substrate 100 and the sealing substrate 200 to each other. However, the filling material 300 can be filled after the substrate 100 and the sealing substrate 200 are attached to each other in accordance with the material.

As an another embodiment, the curing of the filling material 300 dropped on the internal side of the dam member 220 is initiated by heat, electron beam, and/or UV before attaching the substrate 100 and the sealing substrate 200 to each other, and is completely cured and hardened after attaching the substrate 100 and the sealing substrate 200 to each other.

As described above, an inorganic sealing material that effectively shields moisture and/or oxygen seals the light emitting devices so that the life of the light emitting display is increased, and the space between the substrates is filled with the filling material so that mechanical reliability is improved.

In typical light emitting displays, since the space between the substrate and the sealing substrate is empty, the substrate can move, thereby generating Newton's ring and/or increasing the shock sensitivity of the light emitting display. On the other hand, according to some embodiments of the light emitting display, the space between the substrate and the sealing substrate is filled with a filling material with a similar refractivity to the refractivity of the glass substrate, thereby reducing or preventing Newton's ring. Therefore, visibility is improved and a voltage tolerance characteristic between the substrates is improved so that the seal is not as easily damaged by shock.

Although a number of embodiments have been shown and described, those skilled in the art will appreciate that changes might be made in these embodiments without departing from the scope defined in the appended claims.

## Claims

1. A light emitting display comprising:
a first substrate (100) comprising a plurality of light emitting devices (130) disposed thereon;
a second substrate (200) facing the plurality of light emitting devices (130) disposed on the first substrate (100);
a dam member (220) disposed between the first substrate (100) and the second substrate (200), the dam member (220) being arranged to surround the plurality of light emitting devices (130);
an inorganic sealing material (210) comprising frit which can be melted by laser and/or infrared radiation arranged to secure the first substrate (100) and the second substrate (200) to each other, the inorganic sealing material (210) being disposed between the first substrate (100) and the second substrate (200) and around an outer circumference of the dam member (220) to attach the first substrate (100) and the second substrate (200); and
a filling material (300) disposed inward of the dam member (220) and between the first substrate (100) and the second substrate (200), covering the plurality of light emitting devices (130) wherein the filling material (300) is arranged to fill at least some of a space between the plurality of light emitting devices (130) and the second substrate (200) inward of the dam member (220);
**characterized in that** the dam member (220) comprises a frit and the dam member (220) has a reflecting layer (222) formed on the surface of the dam member (220) using a metal having a reflectance in an IR region so as to reflect laser and/or infrared (IR) radiation.

2. A light emitting display according to claim 1, wherein the reflecting layer (222) comprises at least one of Au, Ag, Pt, and Al.

3. A light emitting display according to claim 1 or 2, wherein at least a portion of the dam member (220) is arranged to contact the inorganic sealing material (210).

4. A light emitting display according to claim 1, wherein the frit comprises a transition metal compound.

5. A light emitting display according to any one of claims 1 to 4, wherein the filling material comprises a solid material.

6. A light emitting display according to claim 5, wherein the filling material comprises a heat, electron beam, and/or UV radiation hardening material.

7. A light emitting display according to claim 6, wherein the filling material comprises at least one of epoxy, epoxy acrylate, urethane, urethane acrylate, urethane acrylic, allyl resin, silicone, bisphenol A type epoxy silicone, cycloaliphatic epoxy silicone resin, acrylic epoxy silicone resin, allyl ether silicone, allyl methacrylate silicone, phenyl silicone resin, aliphatic urethane acrylate, and rubber.

8. A light emitting display according to any one of claims 1 to 4, wherein the filling material comprises a liquid material.

9. A light emitting display according to claim 8, wherein the filling material (300)comprises silicone and/or silicone oil.

10. A light emitting display according to claim 8, wherein the filling material (300) comprises at least one of hexamethyldisiloxane, octamethyltrisiloxane, decamethyltetrasioxane, dodecamethylpentasiloxane, and polydimethylsiloxanes.

11. A method of manufacturing a light emitting display comprising:
providing a first substrate (100)comprising a plurality of light emitting devices (130);
providing a second substrate (200) facing the plurality of light emitting devices (130) disposed on the first substrate (100);
disposing an inorganic sealing material (210) comprising frit on an outer circumference of the second substrate (200);
disposing a dam member (220) on the second substrate (200) inward of the inorganic sealing material (210) so as to surround the plurality of light emitting devices (130), wherein the dam member (220) comprises a frit and the dam member (220) has a reflecting layer (222) formed on the surface of the dam member (220) using a metal having a reflectance in an IR region so as to reflect laser and/or infrared (IR) radiation;
disposing a filling material (300) inward of the dam member (220) such that the filling material (300) fills at least some of a space between the plurality of light emitting devices (130) and the second substrate (200) inward of the dam member (220); and
securing the inorganic sealing material (210) to the first substrate (100) and the second substrate (200) by melting the inorganic sealing material (210) by laser and/or infrared radiation, thereby sealing the plurality of light emitting devices (130).

12. A method according to claim 11, wherein disposing the inorganic sealing material (210) comprises:
applying frit paste; and
drying and/or annealing the frit paste.

13. A method according to claim 11, wherein disposing the dam member (220) comprises:
applying frit paste; and
drying and/or annealing the frit paste, thereby hardening the frit paste.

14. A method according to claim 13, wherein at least a portion of the dam member is arranged to contact the inorganic sealing material.

15. A method according to any one of claims 11 to 14, wherein securing the inorganic sealing material (210) to the first substrate (100) and the second substrate (200) to face each other is performed at a pressure lower than atmospheric pressure.

16. A method according to claim 15, wherein the pressure is from 1 Pa to 10,000 Pa.

17. A method according to any one of claims 11 to 16, wherein the filling material (300) comprises a liquid material, the method further comprising compressing the first substrate (100) and the second substrate (200), thereby filling with the liquid filling material spaces between the light emitting devices (130) and the second substrate (200) within the dam member (220).

18. A method according to any one of claims 11 to 16, wherein the filling material (300) comprises a liquid material, the method further comprising hardening the liquid filling material (300).

## Patentansprüche

1. Lichtemittierende Anzeige, Folgendes beinhaltend:
ein erstes Substrat (100), welches eine Vielzahl von lichtemittierenden Vorrichtungen (130) beinhaltet, welche hieran angeordnet ist;
ein zweites Substrat (200), welches der Vielzahl von lichtemittierenden Vorrichtungen (130) zugewandt ist, welche an dem ersten Substrat (100) angeordnet ist;
ein Dammelement (220), welches zwischen dem ersten Substrat (100) und dem zweiten Substrat (200) angeordnet ist, wobei das Dammelement (220) angeordnet ist, um die Vielzahl von lichtemittierenden Vorrichtungen (130) zu umgeben;
ein anorganisches Dichtmaterial (210), welches eine Fritte beinhaltet, welche mittels Laser und/oder Infrarotstrahlung geschmolzen werden kann, welche angeordnet ist, um das erste Substrat (100) und das zweite Substrat (200) aneinander zu sichern, wobei das anorganische Dichtmaterial (210) zwischen dem ersten Substrat (100) und dem zweiten Substrat (200) und um einen äußeren Umfang des Dammelementes (220) angeordnet ist, um das erste Substrat (100) und das zweite Substrat (200) zu befestigen; und
ein Füllmaterial (300), welches einwärts des Dammelementes (220) und zwischen dem ersten Substrat (100) und dem zweiten Substrat (200) angeordnet ist, welches die Vielzahl von lichtemittierenden Vorrichtungen (130) bedeckt, wobei das Füllmaterial (300) angeordnet ist, um mindestens einen Teil eines Raums zwischen der Vielzahl von lichtemittierenden Vorrichtungen (130) und dem zweiten Substrat (200) einwärts vom Dammelement (220) zu füllen;
**dadurch gekennzeichnet, dass** das Dammelement (220) eine Fritte beinhaltet und das Dammelement (220) eine an der Oberfläche des Dammelementes (220) gebildete Reflexionsschicht (222) besitzt, welche ein Metall verwendet, welches ein Reflexionsvermögen in einem IR-Bereich in der Weise besitzt, dass es Laser- und /oder Infrarotstrahlung (IR) reflektiert.

2. Lichtemittierende Anzeige nach Anspruch 1, bei welcher die Reflexionsschicht (222) mindestens eines der Elemente der Gruppe Au, Ag, Pt, und Al beinhaltet.

3. Lichtemittierende Anzeige nach Anspruch 1 oder 2, bei welcher mindestens ein Abschnitt des Dammelementes (220) angeordnet ist, um mit dem anorganischen Dichtmaterial (210) in Kontakt zu gehen.

4. Lichtemittierende Anzeige nach Anspruch 1, bei welcher die Fritte eine Übergangsmetallverbindung beinhaltet.

5. Lichtemittierende Anzeige nach einem der Ansprüche 1 bis 4, bei welcher das Füllmaterial ein festes Material beinhaltet.

6. Lichtemittierende Anzeige nach Anspruch 5, bei welcher das Füllmaterial ein Material beinhaltet, welches durch Hitze, Elektronenstrahl und/oder UV-Strahlung härtet.

7. Lichtemittierende Anzeige nach Anspruch 6, bei welcher das Füllmaterial ein Element der Gruppe beinhaltet, bestehend aus Epoxid, Epoxy-Acrylat, Urethan, Urethanacrylat, Urethanacryl, Alllylharz, Silikon, Epoxidsilikon vom Typ Bisphenol A, zykloaliphatischem Epoxidsilikonharz, Acryl-Epoxidsilikonharz, Allylethersilikon, Allylmethacrylatsilikon, Phenylsilikonharze, aliphatischem Urethanacrylat und Kautschuk.

8. Lichtemittierende Anzeige nach einem der Ansprüche 1 bis 4, bei welcher das Füllmaterial ein flüssiges Material beinhaltet.

9. Lichtemittierende Anzeige nach Anspruch 8, bei welcher das Füllmaterial (300) Silikon und/oder Silikonöl beinhaltet.

10. Lichtemittierende Anzeige nach Anspruch 8, bei welcher das Füllmaterial (300) mindestens ein Element der Gruppe, bestehend aus Hexamethyldisiloxan, Octamethyltrisiloxan, Decamethyltetrasioxan, Dodecamethylpentasiloxan und Polydimethylsiloxan beinhaltet.

11. Verfahren zum Herstellen einer lichtemittierenden Anzeige, Folgendes beinhaltend:
Bereitstellen eines ersten Substrates (100), welches eine Vielzahl von lichtemittierenden Vorrichtungen (130) beinhaltet;
Bereitstellen eines zweiten Substrates (200), welches der Vielzahl von lichtemittierenden Vorrichtungen (130) zugewandt ist, welche an dem ersten Substrat (100) angeordnet ist;
Anordnen eines anorganischen Dichtmaterials (210), welches eine Fritte beinhaltet, an einem äußeren Umfang des zweiten Substrates (200);
Anordnen eines Dammelementes (220) am zweiten Substrat (200) einwärts vom anorganischen Dichtmaterial (210), um so die Vielzahl von lichtemittierenden Vorrichtungen (130) zu umgeben, wobei das Dammelement (220) eine Fritte beinhaltet und das Dammelement (220) eine an der Oberfläche des Dammelementes (220) gebildete Reflexionsschicht (222) besitzt, welche ein Metall verwendet, welches ein Reflexionsvermögen in einem IR-Bereich in der Weise besitzt, dass es Laser- und /oder Infrarotstrahlung (IR) reflektiert;
Anordnen eines Füllmaterials (300) einwärts vom Dammelement (220) in der Weise, dass das Füllmaterial (300) mindestens einen Teil eines Raums zwischen der Vielzahl von lichtemittierenden Vorrichtungen (130) und dem zweiten Substrat (200) einwärts vom Dammelement (220) füllt; und
Sichern des anorganischen Dichtmaterials (210) am ersten Substrat (100) und am zweiten Substrat (200) durch Schmelzen des anorganischen Dichtmaterials (210) mittels Laser und/oder Infrarotstrahlung, wodurch die Vielzahl der lichtemittierenden Vorrichtungen (130) abgedichtet werden.

12. Verfahren nach Anspruch 11, bei welchem Anordnen des anorganischen Dichtmaterials (210) Folgendes beinhaltet:
Auftragen von Frittenpaste; und
Trocknen und/oder Glühen der Frittenpaste.

13. Verfahren nach Anspruch 11, bei welchem Anordnen des Dammelementes (220) Folgendes beinhaltet:
Auftragen von Frittenpaste; und
Trocknen und/oder Glühen der Frittenpaste, wodurch die Frittenpaste gehärtet wird.

14. Verfahren nach Anspruch 13, bei welcher mindestens ein Abschnitt des Dammelementes angeordnet ist, um mit dem anorganischen Dichtmaterial in Kontakt zu gehen.

15. Verfahren nach einem der Ansprüche 11 bis 14, bei welchem Sichern des anorganischen Dichtmaterials (210) am ersten Substrat (100) und am zweiten Substrat (200), damit diese einander zugewandt sind, bei einem Druck erfolgt, der niedriger als Atmosphärendruck ist.

16. Verfahren nach Anspruch 15, bei welchem der Druck zwischen 1 Pa und 10.000 Pa beträgt.

17. Verfahren nach einem der Ansprüche 11 bis 16, bei welchem das Füllmaterial (300) ein flüssiges Material beinhaltet, wobei das Verfahren zudem Komprimieren des ersten Substrates (100) und des zweiten Substrates (200) beinhaltet, wodurch Räume zwischen den lichtemittierenden Vorrichtungen (130) und dem zweiten Substrat (200) innerhalb des Dammelementes (220) mit dem flüssigen Füllmaterial gefüllt werden.

18. Verfahren nach einem der Ansprüche 11 bis 16, bei welchem das Füllmaterial (300) ein flüssiges Material beinhaltet, wobei das Verfahren zudem Härten des flüssigen Füllmaterials (300) beinhaltet.

## Revendications

1. Affichage électroluminescent comprenant :
un premier substrat (100) qui comprend une pluralité de dispositifs électroluminescents (130) qui sont disposés dessus ;
un second substrat (200) qui fait face à la pluralité de dispositifs électroluminescents (130) qui sont disposés sur le premier substrat (100) ;
un élément de barrage (220) qui est disposé entre le premier substrat (100) et le second substrat (200), l'élément de barrage (220) étant agencé de manière à ce qu'il entoure la pluralité de dispositifs électroluminescents (130) ;
un matériau d'étanchéité inorganique (210) qui comprend une fritte qui peut être fondue au moyen d'un rayonnement laser et/ou d'un rayonnement infrarouge, laquelle fritte est agencée de manière à ce qu'elle fixe fermement le premier substrat (100) et le second substrat (200) l'un à l'autre, le matériau d'étanchéité inorganique (210) étant disposé entre le premier substrat (100) et le second substrat (200) ainsi que le long d'une circonférence externe de l'élément de barrage (220) de manière à ce qu'il lie le premier substrat (100) et le second substrat (200) ; et
un matériau de remplissage (300) qui est disposé à l'intérieur de l'élément de barrage (220) ainsi qu'entre le premier substrat (100) et le second substrat (200) et qui recouvre la pluralité de dispositifs électroluminescents (130), dans lequel le matériau de remplissage (300) est agencé de manière à ce qu'il remplisse au moins une certaine part d'un espace qui est situé entre la pluralité de dispositifs électroluminescents (130) et le second substrat (200) à l'intérieur de l'élément de barrage (220) ;
**caractérisé en ce que** l'élément de barrage (220) comprend une fritte et **en ce que** l'élément de barrage (220) comporte une couche réfléchissante (222) qui est formée sur la surface de l'élément de barrage (220) et qui utilise un métal qui présente une réflectance dans une région des IR de manière à ce qu'il réfléchisse un rayonnement laser et/ou un rayonnement infrarouge (IR).

2. Affichage électroluminescent selon la revendication 1, dans lequel la couche réfléchissante (222) comprend au moins un élément chimique pris parmi l'Au, l'Ag, le Pt et l'Al.

3. Affichage électroluminescent selon la revendication 1 ou 2, dans lequel au moins une partie de l'élément de barrage (220) est agencée de manière à ce qu'elle entre en contact avec le matériau d'étanchéité inorganique (210).

4. Affichage électroluminescent selon la revendication 1, dans lequel la fritte comprend un composé de métal de transition.

5. Affichage électroluminescent selon l'une quelconque des revendications 1 à 4, dans lequel le matériau de remplissage comprend un matériau solide.

6. Affichage électroluminescent selon la revendication 5, dans lequel le matériau de remplissage comprend un matériau à durcissement sous l'effet de la chaleur, par faisceau électronique et/ou par rayonnement UV.

7. Affichage électroluminescent selon la revendication 6, dans lequel le matériau de remplissage comprend au moins un matériau pris parmi un époxy, un époxy-acrylate, un uréthane, un uréthane acrylate, un uréthane acrylique, une résine allyle, un silicone, un époxy-silicone du type bisphénol A, une résine époxy-silicone cyclo-aliphatique, une résine époxy-silicone acrylique, un silicone d'éther allylique, un silicone de méthacrylate allylique, une résine silicone de phényle, un uréthane acrylate aliphatique et un caoutchouc.

8. Affichage électroluminescent selon l'une quelconque des revendications 1 à 4, dans lequel le matériau de remplissage comprend un matériau liquide.

9. Affichage électroluminescent selon la revendication 8, dans lequel le matériau de remplissage (300) comprend un silicone et/ou une huile silicone.

10. Affichage électroluminescent selon la revendication 8, dans lequel le matériau de remplissage (300) comprend au moins un corps chimique pris parmi l'hexaméthyldisiloxane, l'octaméthyltrisiloxane, le décaméthyltétrasiloxane, le dodécaméthylpentasiloxane et les polydiméthylsiloxanes.

11. Procédé de fabrication d'un affichage électroluminescent, comprenant :
la fourniture d'un premier substrat (100) qui comprend une pluralité de dispositifs électroluminescents (130) ;
la fourniture d'un second substrat (200) qui fait face à la pluralité de dispositifs électroluminescents (130) qui sont disposés sur le premier substrat (100) ;
la disposition d'un matériau d'étanchéité inorganique (210) qui comprend une fritte sur une circonférence externe du second substrat (200) ;
la disposition d'un élément de barrage (220) sur le second substrat (200) à l'intérieur du matériau d'étanchéité inorganique (210) de manière à ce qu'il entoure la pluralité de dispositifs électroluminescents (130), dans lequel l'élément de barrage (220) comprend une fritte et l'élément de barrage (200) comporte une couche réfléchissante (222) qui est formée sur la surface de l'élément de barrage (220) et qui utilise un métal qui présente une réflectance dans une région des IR de manière à ce qu'il réfléchisse un rayonnement laser et/ou un rayonnement infrarouge (IR) ;
la disposition d'un matériau de remplissage (300) à l'intérieur de l'élément de barrage (220) de telle sorte que le matériau de remplissage (300) remplisse au moins une certaine part d'un espace qui est situé entre la pluralité de dispositifs électroluminescents (130) et le second substrat (200) à l'intérieur de l'élément de barrage (220) ; et
la fixation ferme du matériau d'étanchéité inorganique (210) sur le premier substrat (100) et sur le second substrat (200) en faisant fondre le matériau d'étanchéité inorganique (210) au moyen d'un rayonnement laser et/ou d'un rayonnement infrarouge, d'où ainsi l'étanchéification de la pluralité de dispositifs électroluminescents (130).

12. Procédé selon la revendication 11, dans lequel la disposition du matériau d'étanchéité inorganique (210) comprend :
l'application d'une pâte de fritte ; et
le séchage et/ou le recuit de la pâte de fritte.

13. Procédé selon la revendication 11, dans lequel la disposition de l'élément de barrage (220) comprend :
l'application d'une pâte de fritte ; et
le séchage et/ou le recuit de la pâte de fritte, d'où ainsi le durcissement de la pâte de fritte.

14. Procédé selon la revendication 13, dans lequel au moins une partie de l'élément de barrage est agencée de manière à ce qu'elle entre en contact avec le matériau d'étanchéité inorganique.

15. Procédé selon l'une quelconque des revendications 11 à 14, dans lequel la fixation ferme du matériau d'étanchéité inorganique (210) sur le premier substrat (100) et sur le second substrat (200) de manière à ce qu'il se fassent face l'un l'autre est réalisée à une pression qui est inférieure à la pression atmosphérique.

16. Procédé selon la revendication 15, dans lequel la pression va de 1 Pa à 10 000 Pa.

17. Procédé selon l'une quelconque des revendications 11 à 16, dans lequel le matériau de remplissage (300) comprend un matériau liquide, le procédé comprenant en outre la compression du premier substrat (100) et du second substrat (200), d'où ainsi le remplissage, à l'aide du matériau de remplissage liquide, d'espaces qui sont situés entre les dispositifs électroluminescents (130) et le second substrat (200) à l'intérieur de l'élément de barrage (220).

18. Procédé selon l'une quelconque des revendications 11 à 16, dans lequel le matériau de remplissage (300) comprend un matériau liquide, le procédé comprenant en outre le durcissement du matériau de remplissage liquide (300).
